# EUROPEAN PATENT APPLICATION

(11) **EP 4 249 628 A1**
(43) Date of publication of application: **27.09.2023**
(21) Application number: 22767325.8
(22) Date of filing: 26.01.2022
(51) Int. Cl.: C23C 14/34, C23C 14/16, C23C 4/067, C23C 4/129, C23C 24/04, H01J 37/34

(54) **SPUTTERING TARGET AND MANUFACTURING METHOD THEREFOR**

(30) Priority: 12.03.2021 KR 20210032654; 25.01.2022 KR 20220010619
(71) Applicant: Kolon Industries, Inc., Seoul 07793 (KR)
(72) Inventor: HAM, Gi Su, Seoul 07793 (KR); KIM, Choongnyun Paul, Seoul 07793 (KR); JUNG, Yoo Kyung, Seoul 07793 (KR)
(74) Representative: Ter Meer Steinmeister & Partner
(86) International application number: PCT/KR2022/001346
(87) International publication number: WO 2022/191428

(57) **Abstract**

A sputtering target according to an aspect of the present invention may comprise a substrate; and an alloy target layer, disposed on the substrate, having an amorphous phase at a ratio of 98.0% or higher.

## Description

### [Technical Field]

The present disclosure relates to a sputtering target and a method of manufacturing the same.

### [Background Art]

Sputtering is one vacuum deposition method, which accelerates plasma ionized gas such as argon in a low vacuum to collide with a target and ejects atoms to form a thin film on a plate such as a wafer, glass or a base material. Sputtering has superior deposition ability than general distillation methods, may have excellent ability to maintain an alloy when a complex alloy is used as a sputtering target, and may have excellent deposition ability of heat-resistant metal at high temperature.

As a sputtering target used to form a thin film in a sputtering process, various types of sputtering targets may be used depending on the composition of a thin film or coating to be formed, and a metal having purity of 99.99% or more, an alloy, and a compound material may be used. Titanium, nickel, cobalt, molybdenum, tungsten, tantalum, niobium, niobium pentoxide, aluminum, molybdenum-niobium alloy, stainless steel, nickel alloy, cobalt alloy, and ITO (indium tin oxide) may be mainly used as targets.

Meanwhile, when a columnar structure or a structure including grain boundaries is formed in a thin film formed by sputtering, a corrosion solution may penetrate along the grain boundaries such that corrosion may be accelerated, and accordingly, the film may be vulnerable to corrosion and strength thereof may be lowered. Thus, a technique to form an amorphous thin film which includes an amorphous phase and does not include corrosion resistance and crystalline structure has been studied.

However, a temperature of an amorphous sputtering target may increase due to collision of ions in a sputtering process, and it may be highly likely that the structure around the surface of the sputtering target may change due to the increase in temperature. That is, due to the properties of an amorphous phase which may be thermally unstable, when the temperature of the sputtering target increases, local crystallization may occur on the surface of the sputtering target, and accordingly, brittleness of the target may increase, such that the sputtering target may be easily fractured during the sputtering process. When the sputtering target is fractured during the process, a fatal problem may occur in product production, and thus, it may be necessary to secure stability of the sputtering target.

### [Prior Art Document]

(Reference) Korean Laid-Open Patent Publication No. 10-2019-0109863

### [Disclosure]

### [Technical Problem]

A purpose of the present disclosure is, in order to form an amorphous alloy thin film on a processed target, to provide a sputtering target formed by a desired alloy composition and having a high fraction of amorphous phase and a method for manufacturing the same.

Also, a purpose of the present disclosure is, in order to form an alloy thin film of a desired composition by sputtering, to provide a sputtering target which may perform sputtering using a target of a single plate without using two or more plates .

Also, the present disclosure is to, when a sputtering target having an amorphous alloy is used to form an amorphous alloy thin film on a processed object, address the problem of local crystallization and brittleness of the amorphous alloy occurring on a surface of the sputtering target, and to provide a sputtering target which may, even when a temperature rises locally on the surface due to a sputtering process, reduce an increase in brittleness of the sputtering target caused by crystallization and may not be easily fractured during the process.

### [Technical Solution]

A sputtering target according to an aspect of the present disclosure includes a plate; and an alloy target layer provided on the plate and including an amorphous phase in a fraction of 98.0% or more.

A method of manufacturing a sputtering target according to an aspect of the present disclosure includes preparing a plate; and forming a target layer including an amorphous phase in a fraction of 98. 0% or more by cold spraying an iron (Fe) -based amorphous alloy powder or an iron (Fe) -based alloy powder having a composition having an amorphous forming ability on the plate.

### [Advantageous Effects]

According to an aspect of the present disclosure, a sputtering target may be manufactured by thermal spray an alloy powder including an amorphous phase having a high fraction of or an alloy powder having an excellent amorphous forming ability on a plate, and when an amorphous powder is used for manufacturing a sputtering target, a high amorphous fraction of the amorphous alloy powder may be maintained in a target layer of the sputtering target, such that the amorphous phase fraction of the sputtering target may increase, and a thin film manufactured using the sputtering target may also have a high amorphous fraction.

Also, when the alloy powder is an alloy powder having an excellent amorphous forming ability during the manufacture of the sputtering target, the composition thereof may also be maintained in the target layer, and the thin film manufactured using the sputtering target may be formed of amorphous.

Also, in the case of manufacturing by a thermal spray coating process using amorphous alloy powder, it may be easy to control a size (increasing an area) and a thickness of the sputtering target layer, and a back plate (or a backing plate) may also be freely selected.

Also, as the process of manufacturing the sputtering target may be relatively simplified, the sputtering target may be easily manufactured, and the repair of a damaged area after sputtering may also be possible, such that the effect of reducing the manufacturing costs may be excellent.

Also, when an alloy thin film is manufactured using a sputtering process, sputtering targets of included elements may need to be simultaneously installed in a vacuum chamber, but when a sputtering target is manufactured by a thermal spray coating process using an amorphous alloy powder, only a single sputtering target provided on a single plate may be used, such that the size of a device may be reduced and the manufacturing time may be reduced.

Also, when a sputtering target is manufactured using a thermal spray coating process, a sputtering layer (a coating layer) having high density of 99.99% may be be easily formed, and a cylinder-type sputtering target may be manufactured, which may be advantageous.

### [Brief Description of Drawings]

FIG. 1 is a diagram illustrating a structure of a sputtering device and a sputtering method;
FIG. 2 is a diagram illustrating a cross-sectional microstructure of iron-based amorphous powder manufactured by an atomization process and an XRD analysis result;
FIG. 3 is an image of an iron-based amorphous alloy sputtering target manufactured by a thermal spray coating process;
FIG. 4 is images of a cross-sectional microstructure of an iron-based amorphous alloy target layer manufactured by cold spray (kinetic spray);
FIG. 5 is images of a cross-sectional microstructure of an iron-based amorphous alloy target layer manufactured by HVOF(High velocity oxy-fuel) spray;
FIG. 6 is a XRD analysis result of an amorphous alloy target layer manufactured by cold spray (kinetic spray); and
FIG. 7 is images indicating EPMA analysis result of an amorphous alloy target layer manufactured by cold spray (kinetic spray).

### [Best Mode for Invention]

Before describing the present disclosure in detail below, the terms used herein may be provided to describe specific embodiments, and may not be intended to limit the scope of the present disclosure, which is limited only by the appended claims. It should be understood that all the technical and scientific terms used herein may have the same meaning as commonly understood by those of ordinary skill in the art, unless otherwise indicated.

Throughout this specification and claims, unless otherwise indicated, the term "comprise, comprises, and comprising" may include a mentioned object, step or group of objects, and processes, and may not exclude any other object, step, or group of objects or groups of processes.

Meanwhile, various embodiments of the present disclosure may be combined with any other embodiments unless otherwise indicated. Any feature indicated as particularly preferred or advantageous may be combined with any other feature or features indicated as preferred or advantageous.

In the drawings, a width, length, thickness, or the like of the components may be exaggerated for ease of description. As a whole, the drawings may be described in an observer's point of view, and when it is said that one component is "above/below" or "above/below" another component, the description may include an example in which another component is "directly above/below" the one component and an example in which another component is provided therebetween.

As one aspect of the present disclosure, a sputtering target may include a plate 200 and the target layer 100 provided on the plate 200.

The plate 200 may be a back plate for forming the target layer 100 of the sputtering target, may provide a surface on which the target layer 100 may be formed, and may determine the size of the sputtering target. A material of the plate 200 is not limited, and the plate 200 formed of a metal or alloy material may be used, and a metal, an alloy or a metal oxide material having excellent electrical conductivity and thermal conductivity may be used, and for example, the plate 200 formed of copper metal, indium tin oxide (ITO), indium gallium oxide (IZO), or indium gallium zinc oxide (IGZO) may be used.

The size of the plate 200 is not limited, but when the sputtering target is used as a target of the sputtering process, the size may be varied depending on a sputtering process time, a speed, and the amount of operation, and may be determined depending on the method and conditions for manufacturing the sputtering target.

A bonding layer may be provided between the plate 200 and the target layer 100 to be described later. When bonding between the target layer 100 and the plate 200 provided on the plate 200 is not good, there may be a problem in which the target layer 100 may be peeled off. For example, to supplement the bonding properties of the plate 200, a bonding layer such as elastomer may be provided, and when excellent bonding between the plate 200 and the bonding layer is not required, the target layer 100 may be formed directly on the plate 200 without a bonding layer.

The target layer 100 may be an alloy layer provided on the plate 200, and may be provided on the surface of the plate 200 or the bonding layer. The target layer 100 may be formed of an alloy composition having an excellent amorphous forming ability, and may be an amorphous alloy layer including an amorphous phase.

Specifically, an alloy included in the target layer 100 may be an iron-based alloy having a composition including iron (Fe) as a main component, and may be preferably an iron-based amorphous alloy including elements improving the amorphous forming ability. As an amorphous sputtering target material, a portion of K, Sr, Eu, Ca, Y, Pb, Er, In, Zr, or the like, which are large atoms which may improve the amorphous forming ability, may be included, Ni, Cr, Co, Cu, V, Mo, W, Pt, Nb, Ta, Au, Ag, Ti, or the like, which may be intermediate atoms, may be included, and P, S, B, and C, which may be small atoms, may be added.

The iron-based alloy in an embodiment of the present disclosure may include Fe, Cr and Mo, and may further include at least one element selected from a group consisting of Ni, Co, Cu, V, W, Pt, Nb, Ta, Au, Ag, Ti, P, S, B and C, and two or more elements selected from the element group may be included.

Meanwhile, at least one or more elements selected from the group consisting of Ni, Co, Cu, V, W, Pt, Nb, Ta, Au, Ag, Ti, P, S, B and C further included may be included each within 10 wt% in the total alloy.

When the at least one element selected exceeds 10 wt.%, due to degradation of an amorphous forming ability of an alloy and a decrease in a glass transition temperature (Tg) and a crystallization temperature (Tx), a fraction of the amorphous phase may be lowered or crystallization may easily occur. Also, accordingly, crystallization may easily occur in the target layer 100 by heat generated during sputtering, which may cause cracks in the target or non-uniformity in composition of the alloy thin film 300 manufactured by sputtering.

When the alloy forming the target layer 100 has the above composition, the iron-based alloy target layer 100 including an alloy having an excellent amorphous forming ability may be provided. In this case, an amorphous phase may be included in the target layer 100 in a high fraction, and even when the target layer 100 does not include an amorphous phase or may include an amorphous phase in a low fraction, a high fraction of an amorphous phase may be obtained in a finally obtained thin film.

The fraction of the amorphous phase included in the target layer 100 may be preferably 80 to 100%, preferably 90 to 100%, more preferably 95 to 100%.

When the fraction of the amorphous phase is lower than the corresponding range, the fraction of a crystalline phase may increase, and compositional uniformity of the sputtering thin film may decrease due to non-uniform distribution of the elements forming the crystalline phase in the alloy. Also, due to an increase in brittleness of the target layer 100 due to an increase in the fraction of a crystalline phase, or a decrease in a glass transition temperature (Tg) and a crystallization temperature (Tx) of the alloy in a portion of the target layer 100 in which a crystalline phase is formed, an amorphous forming ability may be lowered, and additional crystallization caused by an increase in temperature occurring during sputtering may occur locally, such that cracks may be created in the target layer 100.

Meanwhile, a thickness of the target layer 100 may not be significantly limited, and may be easily controlled according to an applied technical field and requirements of a product, but the thickness may be in the range of 50 um to 4000 um, preferably 100 um to 4000 µm.

As a method for manufacturing the target layer 100 formed of an alloy including an amorphous phase, a method for forming the target layer 100 by a thermal spray coating process after powdering an alloy, a method for depositing or sputtering an alloy, a method of manufacturing as a ribbon and a thin film and forming or sintering at a high temperature, and a method of casting, casting, or pressing may be used, and preferably, a method of forming the target layer 100 by thermal spray coating of an alloy powder may be used.

When a sputtering target is manufactured by a thermal spray coating process using an amorphous alloy powder, a process of rapidly cooling the alloy powder at a fast cooling rate (~106K/s) after completely melting the alloy powder may be included, and the target layer 100 may be formed while maintaining the amorphous phase of the powder as is by controlling a spraying temperature, which may be advantage in that the thickness and size may be easily controlled.

However, in the case of a method of forming or sintering at a high temperature, a method of casting, pressing or pressing, a method of depositing or sputtering, or the like, it may be difficult to provide a fast cooling rate (~10⁶K/s), such that it may be difficult to form a short range ordered structure, as a process of additional bonding with a back plate (or a backing plate) may be added, which may degrade productivity and economic feasibility.

More specifically, the target layer 100 may be manufactured by various thermal spraying methods, and among the method, HVOF (High velocity oxy-fuel) spraying, plasma spraying (plasma spray), flame spraying (flame spray), arc spraying (arc spray), twin wire arc spray (TWAS) and thermal spray method including cold spray, or the like, may be preferably used.

When the thermal spray method is used as a method of forming the target layer 100, an alloy powder having a desired alloy composition may be used, and the coating method and conditions may be easily controlled. Also, when an alloy powder including an amorphous phase is used as a thermal spraying material (feedstock), the target layer 100 may be formed while maintaining the fraction of the amorphous phase included in the powder to be in a high level, such that it may be advantageous to form an amorphous phase having an amorphous phase of a high fraction.

An embodiment of the present disclosure discloses a sputtering target including the target layer 100 formed by a thermal spraying method, and a sputtering target having the target layer 100 by using a cold spray(kinetic spray) method among thermal spraying methods.

In the case of a thermal spray coating process based on a high temperature such as atmospheric plasma spray (APS), arc spray, high-speed flame spray (HVOF spray), the powder is laminated in a temperature section higher than a glass transition temperature (Tg) or a crystallization temperature (Tx), such that oxidation of the powder may occur by inflight oxidation, in which the powder is oxidized by a high heat source during flight, which may cause depletion of metal elements. The depletion of additional elements may locally reduce the glass forming ability of the coating layer, such that crystallization of the alloy may occur in the depleted zone.

However, by using the cold spray (kinetic spray) process, this problem may not occur, such that an overall amorphous fraction of the target may be higher than that of materials manufactured by other thermal spray coating processes, a uniform amorphous phase fraction may be obtained, and purity and density may be also higher, which may be advantageous.
cold spray(kinetic spray) process may be a technique of, by accelerating a metal or composite material powder at a supersonic speed of about 500 to 1200 m/s using a high-pressure compressed gas, such as helium, nitrogen, argon, or a mixed gas to induce plastic deformation of the powder and to deposite the powder on a substrate, forming a dense coating layer, and as the powder is not melted at a low temperature but may be laminated in a solid state such that plastic deformation may occur by kinetic energy, and thus, the technique may be applied to copper and titanium materials highly reactive with oxygen at high temperatures or may be used as a method of thermal spraying amorphous and nanocrystalline materials having low phase stability, and may have an advantage of maintaining properties (purity, composition, or the like) of an initial powder.

Also, in the case of forming the target layer 100 by a thermal spraying method using an amorphous alloy powder, the formed thermal spraying layer may be provided on the plate 200 or a base material, and thus, there may be an advantage in that the bonding process required to bond the target layer 100 to a general plate 200 may be omitted.

Additionally, a method of manufacturing a sputtering target by laminating powder through the thermal spray coating process may be also preferably used for maintenance and repair of a waste sputtering target.

The formed target layer 100 may partially have different properties depending on a composition of an alloy included in an alloy powder, a fraction of the amorphous phase, a thermal spraying method, and thermal spraying conditions. The target layer 100 may have no oxide in a particle boundary, such that purity of the coating layer may be similar (low impurity content) to that of the powder, porosity may be very low, and a fraction of an amorphous phase may be obtained at a level similar to that of feedstock.

Specifically, a content of impurities included in the target layer 100 may be 0.05 wt.% or less, preferably 0.001 to 0.04 wt.%, more preferably 0.001 to 0.005 wt.%. When the impurity content is higher than the corresponding range, the composition of the thin film and the composition of the powder may be different, which may cause deterioration of expected properties (abrasion resistance, corrosion resistance, or the like).

Here, impurities may include impurities entering from the outside, and may also include elements such as nitrogen and oxygen present in a grain boundary in a trace amount in the process of forming the target layer 100, oxide of metal formed by inflight oxidation, ceramic phases in which metal atoms are chemically combined with non-metal atoms, intermetallic compounds, or the like, and may include foreign substances, and also new compounds and crystalline phases not included in the amorphous alloy powder.

Also, porosity of the target layer 100 may be 0.1% or less. More preferably, porosity may be 0.01 to 0.1%. When porosity of the target layer 100 is higher than the corresponding range, there may be a problem in that peeling of the target layer 100 and roughness of the thin film may increase during sputtering, such that quality of final product may degrade.

Also, a fraction of an amorphous phase included in the target layer 100 may be preferably 98.0% or more, preferably 99.0% or more, more preferably 99.5% or more, and may be in the range of 0.96 to 1 times, preferably 0.98 to 1 times, as compared to the fraction of an amorphous phase included in an amorphous alloy powder used for coating. When the fraction of an amorphous phase included in the target layer 100 is lower than the corresponding range, or includes an amorphous phase in a fraction lower than that of the amorphous alloy powder, there may be a difference in a local compositional of a thin film, which may cause deterioration of properties.

Also, strength or Vickers hardness (HV0.3) of the sputtering target layer 100 may be 900 to 1100 Hv similarly to that of an initial powder, and may be preferably 1000 to 1100 Hv. When strength or Vickers hardness is low, there may be a possibility that there may be a difference in compositions in different positions of the coating layer, and it may be understood that bonding strength of a grain boundary of the powder may be lowered. In this case, while sputtering is performed, a composition of the thin film may be different from that of the target layer 100, or a portion of the target layer 100 may be peeled off and may fall on the thin film, which may cause a product defect.

Meanwhile, a size and shape of an amorphous alloy powder used in the thermal spray process for forming the target layer 100 is not limited, but may be preferably a powder similar to a spherical shape, and an average particle diameter of the alloy powder may be 40 µm or less, and may be preferably 30 µm or less.

When a particle size is smaller than the corresponding range, kinetic energy of the powder may be lowered and deposition efficiency may be reduced, such that economic efficiency in manufacturing the sputtering target may be lowered, and a specific surface area per unit g may increase such that metal oxide may be formed by inflight oxidation, and when the size is larger than the corresponding range, there may be a problem in that deformation of the powder may not be induced such that porosity of the target layer 100 may increase.

In an embodiment of the present disclosure, a sputtering target may be formed by cold spray (kinetic spray) an amorphous alloy powder on the plate 200 or a sputtering target obtained by a heat treatment if necessary may be provided. When a heat treatment is performed after cold spray (kinetic spray), a heat treatment may be performed within a temperature range in which oxides are not formed or crystallization does not occur, and during heat treatment, an alloy of the target layer 100 may maintain an amorphous phase and porosity may decrease such that density of the target layer 100 may improve.

In this case, as a heat treatment atmosphere, vacuum atmosphere or Ar atmosphere may be suitable for the heat treatment, the heat treatment may be performed at 550 to 570°C, and may be preferably performed at 560 to 570°C. When the heat treatment temperature is lower than the corresponding range, the pore improvement effect may not be obtained, such that it may be difficult to improve density of the coating layer.

The sputtering target according to this aspect of the present disclosure may be preferably used as a single target which may form an alloy thin film 300 of the same composition as that of the target layer 100 on the surface of the processed object 400 by colliding ionized gas atoms with the surface during sputtering, and the using the target as a single target may indicate that the sputtering target in which a target layer 100 formed of an alloy of a single composition is formed on a single plate 200 may be uniquely used in the sputtering process .

An alloy of a single composition may indicate that the alloy includes completely different elements or excludes cases in which the contents of included elements are different from each other, and may include the case in which impurities may be partially included in the process of forming the target layer 100or the difference contents thereof may be negligible, and even if the included amorphous phase fraction is different, the alloys may be configured to have the same composition.

The alloy included in the target layer 100 may be an iron-based amorphous alloy having an excellent glass forming ability, and a fraction of an amorphous phase, a glass transition temperature (T_{g}), and a crystallization temperature (Tₓ) may be high, such that crystallization may not easily occur even when the temperature of the local target rises during the sputtering process, and accordingly, brittleness properties may be good, such that cracks may not be hardly created in the sputtering target.

Also, when the sputtering target formed by the thermal spray coating process is used as a single target for the sputtering process, due to the excellent properties (high glass forming ability) of the aforementioned target layer 100 and a sound microstructure (very low porosity and powder interfacial defect) of the target layer 100 obtained by the thermal spray coating process, even when the target temperature increases during the sputtering process, formation of cracks in the target layer 100 due to deterioration of physical properties in microstructural defects (pores and powder interfacial defects) may be prevented.

Another aspect of the present disclosure may be a method for manufacturing a sputtering target, and the method may include preparing the iron-based alloy powder and the plate 200, and forming the target layer 100 by thermal spraying the iron-based amorphous alloy powder on the aforementioned plate 200.

As the iron-based alloy powder, preferably the same amorphous alloy powder as described above may be used, and it may be preferable to use an alloy powder having a high glass forming ability even when an amorphous phase is not included. It may be preferable that the plate 200 be electrically connected to a cathode during the sputtering process in the same manner as described above such that ionized gas atoms may be accelerated toward the target layer 100.

As for the thermal spray method, various methods may be used, and it may be most preferable that a cold spray method be used.

According to the corresponding aspect of the present disclosure, when a thin film including an amorphous phase is manufactured through a sputtering method, to provide an alloy of a composition having excellent glass forming ability as a target, a single sputtering target may be used as compared to the method of performing sputtering using two or more targets calculated by the alloy composition fraction, and accordingly, there may be an advantage in which composition uniformity of the thin film may be obtained and sputtering process may be simplified, and there may be an advantage in solving the problem that it may be difficult to manufacture a target of an amorphous alloy composition by sintering or casting.

The target plate 200 of the aforementioned sputtering target may be used as is during the sputtering process as a back plate, may be a single plate, and may be connected to a DC or AC power source and may work as a cathode (a negative electrode) . The target layer 100 provided on the plate 200 may provide a surface on which sputtering occurs, such that an alloy included in the target layer 100 of the sputtering target may be a target of sputtering during the sputtering process, and may form an alloy thin film 300 of the same composition on the processed object 400 such as a substrate or the plate 200 working as an anode (positive electrode).

The apparatus and sputtering conditions used for sputtering are not limited, and may be carried out in devices and under conditions employable at a general level of technology.

Another aspect of the present disclosure relates to a structure including an alloy thin film and an alloy thin film formed using the aforementioned sputtering target as a sputtering target.

The thin film produced by sputtering preferably may include an alloy of the same composition as the target layer 100, and some errors may occur in the measurement method or obtaining a sample, but the composition of the thin film formed by the sputtering process may have the same composition as that of the target layer 100 serving as a sputtering target.

Particularly, in the thin film manufactured by sputtering, when the target layer 100 used as the sputtering target includes an amorphous phase, an amorphous phase of the target layer 100 may be included, and a difference between the fraction of an amorphous phase included in the thin film and the fraction of the amorphous phase included in the target layer 100 may be preferably 0%, but may be within 5%, or preferably 0.1 to 5%.

Also, the powder laminated structure of the target layer 100 formed by the thermal spraying method may reduce a chemical reaction or impurity formation between the alloy powders or in the alloy powder during the sputtering process, such that an alloy of the desired composition may be applied to the thin film as is, which may be advantageous.

### [Best Mode for Invention]

Hereinafter, the present disclosure will be described in greater detail through embodiments.

### (Embodiment)

### Manufacturing sputtering target

As Fe-based amorphous alloy powder, an iron-based amorphous alloy including powder Cr and Mo, which may be medium atoms, and B and C, which may be small atoms, where the content of each component were Cr: 15.8 wt.%, Mo : 27.0 wt.%, B : 1.2 wt.%, C: 3.7 wt.%, and a balance of Fe, and having an average particle size as in Table 1 was prepared. Thereafter, a target layer having a thickness as in Table 1 was formed by applying each alloy powder on a stainless steel plate using a cold spray method, a high-speed flame spray (HVOF) method, and an atmospheric plasma spray (APS) method.

**[Table 1]**

| Sample No. | Alloy compositi on | Crystal line state | Alloy powder average particle size (µm) | Thickne ss of target layer (µm) | Coating method | Plate |
|---|---|---|---|---|---|---|
| 1 | Fe-Mo-Cr-B | Amorpho us | 29.5 | 420 | Cold spray | Stainles s steel |
| 2 | Fe-Mo-Cr-B | Amorpho us | 29.5 | 250 | HVOF spray | Stainles s steel |
| 3 | Fe-Mo-Cr-B | Amorpho us | 17.0 | 300 | Cold spray | Stainles s steel |
| 4 | Fe-Mo-Cr-B | Amorpho us | 17.0 | 110 | HVOF spray | Stainles s steel |
| 5 | Fe-Mo-Cr-B | Amorpho us | 48.5 | 320 | Cold spray | Stainles s steel |
| 6 | Fe-Mo-Cr-B | Amorpho us | 48.5 | 210 | HVOF spray | Stainles s steel |
| 7 | Fe-Mo-Cr-B | Amorpho us | 29.5 | 400 | Atmospheric plasma spray | Stainles s steel |

### (Experimental example)

### Experimental Example 1 - Analysis of structure of iron-based amorphous powder

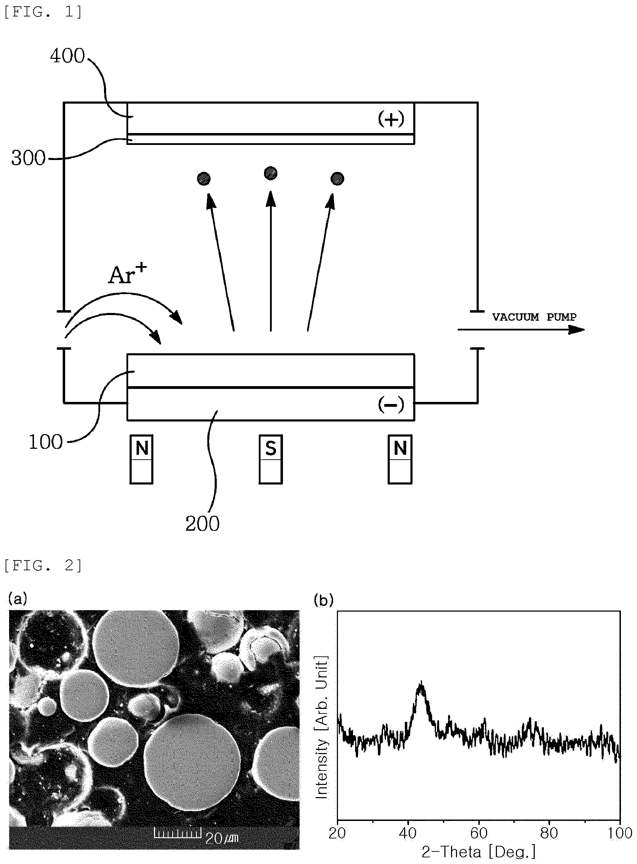

The cross-sectional microstructure of the iron-based amorphous alloy powder in Table 1 was observed with an electron microscope, and X-Ray diffraction analysis of the iron-based amorphous alloy powder was performed, and the results are listed in FIG. 2.

FIG. 2(a) is an image of a cross-sectional microstructure of the powder, it was observed that the powder had a spherical shape as a whole, and an average particle size was 29.5 um. In the result of (b) in FIG. 2, a crystalline peak was not detected, and only a broad halo peak was detected, and thus, it was determined that every powder maintained an amorphous phase.

### Experimental Example 2 - Analysis of structural properties of target layer

The alloy composition and the presence of impurities or foreign substances were identified for the alloy coating layer and alloy powder of samples 1 to 6 through ICP analysis, a crystal structure was analyzed using X-ray diffraction (XRD) analysis, and a microstructure (porosity and distribution of elements) of the coating layer was identified using a Field Emission Scanning Electron Microscope and a Field Emission Electron Probe Micro Analyzer.

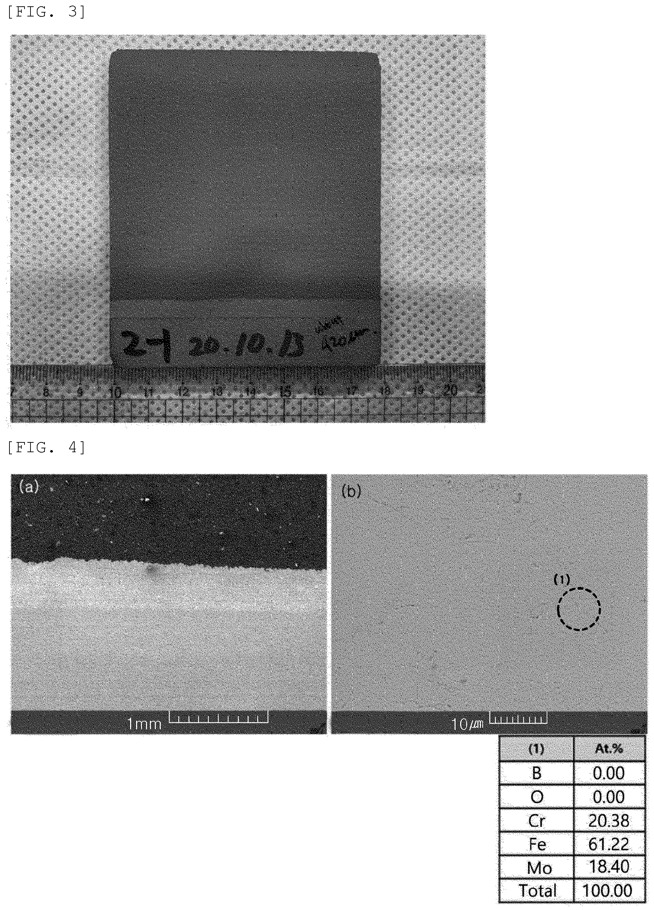

FIG. 3 is an image obtained after a sputtering target is manufactured using the iron-based amorphous powder of sample 1 in a zone having a width and height of 8 cm on a base material.

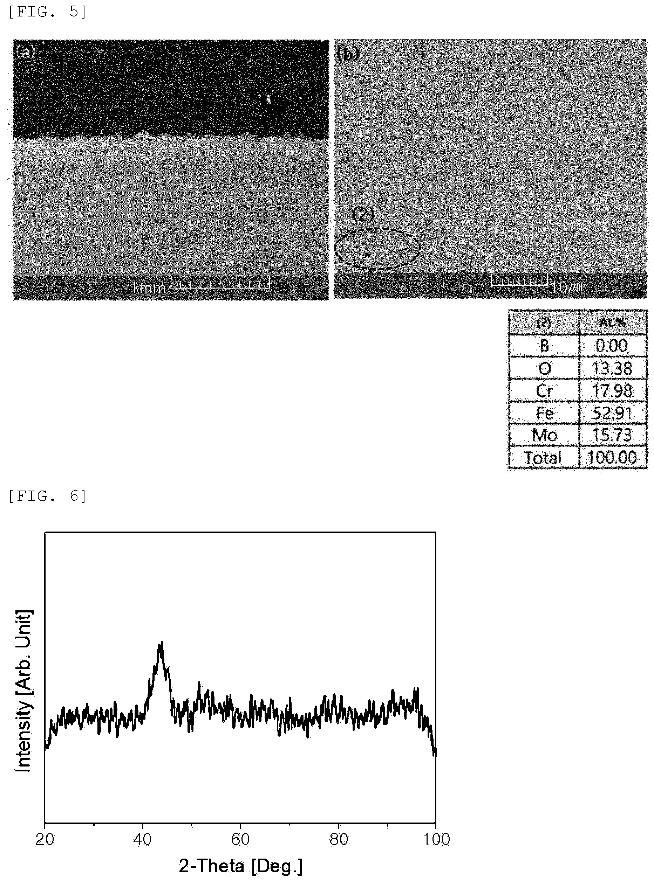

FIGS. 4 and 5 are image of a cross-sectional surface and a microstructure of the iron-based amorphous alloy target layer manufactured by a cold spray (kinetic spray) process and an HVOF (High velocity oxy-fule) spray process using the powders of samples 1 and 2, respectively.

In FIG. 4(a), a thickness of the target layer was measured to be 420 µm, and no defects or impurities were observed inside the target layer and in the interfacial region between the target layer and the substrate.

4 (b) is an image of a microstructure of the target layer when observed at high magnification, and no oxide was detected in a grain boundary in the portion indicated by (1), which indicates that the target layer included the same level of impurities as the initial powder.

In FIG. 5(a), bonding was not observed in the target layer and on the interfacial surface between the target layer and the base material, but it was observed that some pores were present in the grain boundary. In FIG. 5(b), a region between the grain boundaries was clearly observed, and it was analyzed that the Fe-Cr-based composite oxide was present in the portion indicated by (2), such that it was expected that the content of impurities in the target layer was high as compared to the target layer of the cold spray process in FIG. 4, and the content of impurities included in the target layer was higher than the content of impurities included in the iron-based amorphous alloy powder used for the manufacturing.

FIG. 6 is a XRD analysis result of an amorphous alloy target layer manufactured by cold spray process of sample 1. As a result of the analysis, when the target layer was formed by the cold spray method using the iron-based amorphous alloy powder of sample 1, the peak of the crystalline phase was not detected as in the powder used as in FIG. 2(a), and only the broad halo peak was detected, indicating that an amorphous phase was maintained as in the powder.

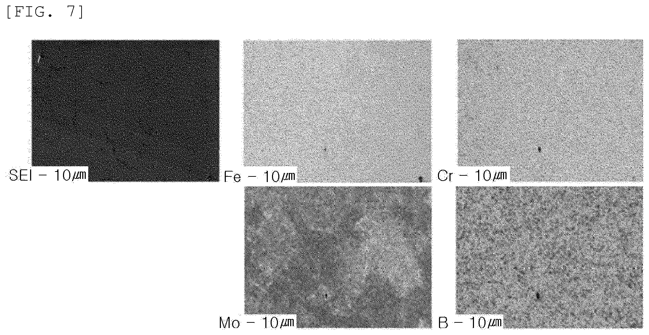

FIG. 7 is images indicating EPMA analysis result of an amorphous alloy target layer manufactured by cold spray process, and as a result of the analysis, Fe, Cr, Mo and B included in the alloy were evenly and finely distributed, and segregation of alloying elements by precipitation was not observed.

### Experimental Example 3 - Analysis of physical properties of sputtering target

The amorphous fraction, porosity and hardness of the alloy powder and sputtering target layer used in samples 1 to 7 were measured, and crack density was observed after surface polishing of the target material. Based on results of the microstructure analysis of the target layer, evaluation based on four levels, very good, excellent, good, and bad, were performed.

The results of experimental examples 1 and 3 are summarized and listed in Table 2 below.

**[Table 2]**

| | Alloy powder | | Sputtering target | | | | Evalua tion |
|---|---|---|---|---|---|---|---|
| | Amorphou s Phase Fraction [%] | Hardness [Hv_{0.3}] | Amorphou s Phase Fraction [%] | Hardness [HV_{0.3}] | Porosity [%] | Crack density [cracks/c m²] | |
| 1 | 99.9 | 1100.3 | 99.9 | 1096.2 | 0.01 | 0 | ⊚ |
| 2 | 99.9 | 1101.2 | 99.9 | 897.1 | 0.05 | 0 | ○ |
| 3 | 99.9 | 1023.4 | 99.9 | 965.0 | 0.02 | 0 | ⊚ |
| 4 | 99.9 | 1035.7 | 98.6 | 880.3 | 0.1 | 1 | ○ |
| 5 | 99.9 | 1132.0 | 99.9 | 923.5 | 0.05 | 0 | ○ |
| 6 | 99.9 | 1100.3 | 97.0 | 787.6 | 0.13 | 1 | ○ |
| 7 | 99.9 | 1130.1 | 74.2 | 607.1 | 7.5 | 3 | X |

| | | | | | | | |
|---|---|---|---|---|---|---|---|
| (⊚: very good, ∘: good, Δ: good X: bad) | | | | | | | |

### Experimental Example 4 - Evaluation of sputtering target surface after performing sputtering

Sputtering was performed using samples 1 to 7, and after sputtering, visual evaluation of the surface of the target material used and crack density measurement using an optical microscope were performed, and evaluation based on four levels, very good, excellent, good, and bad was performed and was listed in Table 3 below.

**[Table 3]**

| | Visual evaluation | Crack Density (cracks/cm²) | Comprehensive evaluation |
|---|---|---|---|
| 1 | ⊚ | 0 | ⊚ |
| 2 | ⊚ | 0 | ○ |
| 3 | ⊚ | 0 | ⊚ |
| 4 | ⊚ | 1 | ○ |
| 5 | ⊚ | 0 | ○ |
| 6 | ⊚ | 1 | ○ |
| 7 | Δ | 3 | X |

| | | | |
|---|---|---|---|
| (⊚: very good, ∘: good, Δ: good X: bad) | | | |

While the example embodiments have been illustrated and described above, it will be apparent to those skilled in the art that modifications and variations could be made without departing from the scope of the present disclosure as defined by the appended claims.

### (Description of reference numerals)

- 100 :: Target layer
- 200 :: Plate
- 300 :: Alloy thin film
- 400 :: Processed object

## Claims

1. A sputtering target, comprising:
a plate; and
an alloy target layer provided on the plate and including an amorphous phase in a fraction of 98.0% or more.

2. The sputtering target of claim 1, wherein porosity of the target layer is 0.1% or less.

3. The sputtering target of claim 1, wherein the target layer includes an iron (Fe)-based alloy including Cr and Mo.

4. The sputtering target of claim 3, wherein the iron (Fe)-based alloy includes at least one element selected from a group consisting of Ni, Co, Cu, V, W, Pt, Nb, Ta, Au Ag, Ti, P, S, B and C each by 10 wt.% or less.

5. The sputtering target of claim 1, wherein a thickness of the target layer is 50 to 4000 um.

6. The sputtering target of claim 1, wherein the plate is a single plate, and the target layer provided on the plate has a single composition.

7. A method of manufacturing a sputtering target, the method comprising:
preparing a plate; and
forming a target layer including an amorphous phase in a fraction of 98.0% or more by cold spraying an iron (Fe)-based amorphous alloy powder or an iron (Fe)-based alloy powder having a composition having an amorphous forming ability on the plate.

8. The method of claim 7, wherein the iron (Fe)-based alloy powder is an iron (Fe)-based alloy powder including Cr and Mo.

9. The method of claim 8, wherein the iron (Fe)-based alloy includes at least one element selected from a group consisting of Ni, Co, Cu, V, W, Pt, Nb, Ta, Au Ag, Ti, P, S, B and C each by 10 wt.% or less.

10. The method of claim 7,
wherein the iron (Fe)-based alloy powder has an average particle size of 40 µm or less, and
wherein porosity of the target layer is 0.1% or less.

11. The method of claim 7, wherein a thickness of the target layer is 50 to 4000 um.

12. The method of claim 7, wherein a fraction of an amorphous phase included in the target layer is 0.96 times to 1 times a fraction of an amorphous phase included in the iron (Fe)-based alloy powder.

13. The method of claim 7, further comprising:
performing a heat treatment on the sputtering target at a temperature lower than a crystallization temperature (Tx) of the iron (Fe)-based alloy powder.

14. A method of manufacturing an alloy thin film, the method comprising:
depositing elements included in a target layer on a processed object by colliding ionized gas atoms with a sputtering target manufactured by one of claims 7 to 13.
